# EUROPÄISCHE PATENTSCHRIFT

(11) **EP 3 926 180 B1**
(45) Veröffentlichungstag und Bekanntmachung des Hinweises auf die Patenterteilung: **03.05.2023**
(21) Anmeldenummer: 21176720.7
(22) Anmeldetag: 28.05.2021
(51) Int. Cl.: F16B 5/00, F16B 1/04, H01L 41/09, H01L 41/08, H01L 41/193

(54) **BEFESTIGUNGSANORDNUNG MIT EINEM BEFESTIGUNGSELEMENT MIT EINEM ELEKTROAKTIVEN POLYMERAKTUATOR**
FIXING ARRANGEMENT WITH A FIXING ELEMENT WITH AN ELECTROACTIVE POLYMER ACTUATOR
DISPOSITIF DE FIXATION DOTÉ D'UN ÉLÉMENT DE FIXATION DOTÉ D'UN ACTIONNEUR ÉLECTROACTIF EN POLYMÈRE

(30) Priorität: 19.06.2020 DE 102020116253
(43) Veröffentlichungstag der Anmeldung: 22.12.2021
(73) Patentinhaber: Airbus Operations GmbH, 21129 Hamburg (DE)
(72) Erfinder: Linde, Peter, 21129 Hamburg (DE); Hegenbart, Matthias, 21129 Hamburg (DE); Benthien, Hermann, 21129 Hamburg (DE); Tölle, Lisa, 21129 Hamburg (DE)

(56) Entgegenhaltungen:
- EP-A2- 1 621 146
- US-A1- 2009 177 261
- RASMUSSEN LENORE ET AL: "Synthetic Muscle electroactive polymer (EAP) shape-morphing and pressure sensing for robotic grippers", SPIE PROCEEDINGS; [PROCEEDINGS OF SPIE ISSN 0277-786X], SPIE, US, Bd. 11375, 21. Mai 2020 (2020-05-21), Seiten 1137505-1137505, XP060131476, DOI: 10.1117/12.2558965 ISBN: 978-1-5106-3673-6

## Beschreibung

Die vorliegende Erfindung betrifft eine Befestigungsanordnung mit einem Befestigungselement mit einem elektroaktiven Polymeraktuator.

Aus dem Stand der Technik sind eine Vielzahl von Konzepten bekannt, bei denen Befestigungsanordnungen mit wenigstens einem Befestigungselement verwendet werden, um zwei Bauteile miteinander zu verbinden. Zu diesen Konzepten zählen Schraubverbindungen, bei denen die Befestigungsanordnung als Befestigungselement eine Schraube oder einen Bolzen mit einem Gewinde sowie entweder eine Mutter oder ein in ein Bauteil eingebrachtes Gewinde als Gegenstück umfasst. Ferner ist es bekannt, Nietverbindungen einzusetzen, bei denen ein Ende eines Niets nach dem Einbringen in ein sich durch die zwei zu verbindenden Bauteile erstreckende Bohrung eingebracht worden ist, verformt wird.

Weiterhin sind beispielsweise Befestigungsanordnungen bekannt, bei denen mit Hilfe von sogenannten Kabelbindern oder Schellen Kabel und Rohrleitungen zusammengehalten und/oder an anderen Bauteilen befestigt werden.

All diesen Befestigungsanordnungen ist gemein, dass die Verbindung zwischen dem Befestigungselement und dem jeweiligen Bauteil und/oder dem Gegenstück zum einen nur unter großem Aufwand hergestellt werden kann, wobei auch erhebliche mechanische Belastungen auf das Bauteil ausgeübt werden. So werden beim Festziehen einer Schraubverbindung die Bauteile, die mit der Verbindung verbunden werden, zusammengepresst oder es werden Zugbelastungen auf das Bauteil ausgeübt, in dem ein Gewinde eingebracht ist. Diese Belastungen sind erforderlich, damit die Schraubverbindungen hinreichend fest angezogen werden, um ein späteres selbsttätiges Lösen zu verhindern. Dabei können die während des Herstellens der Verbindungen auftretenden Belastungen auf die Bauteile leicht die überschreiten, die später auftreten, wenn die Verbindung belastet wird. Gleiches gilt auch beim Herstellen einer Nietverbindung, bei der bei der erforderlichen Verformung des Niets erhebliche Kräfte auf die zu verbindenden Bauteil wirken.

Zum anderen ergibt sich bei den zuvor beschriebenen Befestigungsanordnungen das Problem, dass sich diese nur unter großem Aufwand oder nur unter Zerstörung des Befestigungselements oder des Gegenstücks wieder lösen lassen.

Weiterhin ist es aus der US 2004/074069 für eine Befestigungsanordnung bekannt, dass eine elektroaktive Polymerschicht auf Vorsprüngen an einem ersten Bauteil aufgebracht ist, die in Aussparungen an einem zweiten Bauteil eingesetzt werden, wobei sich die Polymerschicht ausdehnt, wenn Spannung an die Schicht angelegt wird.

Die Patentschrift EP1621146 zeigt ein chirurgisches Instrument mit einem Gelenksperrmechanismus, das von zwei EAP Stapeln gesteuert wird, auf.

US2009177261 offenbart ein Ablösemechanismus aus einem elektroaktiven Polymerring für eine implantierbare Vorrichtung mit Materialien, die bei Anwendung von Wärme/elektrischer Energie ihre Konfiguration ändern.

RASMUSSEN LENORE ET AL, "Synthetic Muscle electroactive polymer (EAP) shape-morphing and pressure sensing for robotic grippers" Bd. 11375 in SPIE PROCEEDINGS; [PROCEEDINGS OF SPIE ISSN 0277-786X], SPIE, US, 21.05.2020 offenbart einen sensitiven elektroaktiven Polymeraktuator in einem Robotergreifarm.

Daher ist es ausgehend vom Stand der Technik die Aufgabe der vorliegenden Erfindung, eine Befestigungsanordnung bereitzustellen, die mit geringem Aufwand in Eingriff gebracht werden kann, die bei der Montage keine großen Belastungen auf die beteiligten Bauteile ausübt und die leicht wieder gelöst werden kann.

Gemäß der vorliegenden Erfindung wird diese Aufgabe gelöst durch eine Befestigungsanordnung mit einem Befestigungselement, das ein Basisteil und ein erstes Verriegelungselement und ein zweites Verriegelungselement aufweist, wobei das erste und das zweite Verriegelungselement an dem Basisteil befestigt sind und eine Verriegelungsstellung und eine Lösestellung einnehmen können.

Erfindungsgemäß umfasst die Befestigungsanordnung demnach wenigstens ein Befestigungselement, das unmittelbar mit einem Bauteil verbunden werden kann, um daran ein weiteres Element beispielsweise in Form eines weiteren Bauteils der eines Kabels oder eines Rohrelements zu haltern. Es ist aber auch möglich, dass die Befestigungsanordnung ein separates Gegenstück umfasst, das mit dem Befestigungselement lösbar verbunden werden kann.

Weiterhin ist die erfindungsgemäße Befestigungsanordnung derart ausgebildet, dass das Basisteil einen ersten elektroaktiven Polymeraktuator aufweist, der eine erste vorzugsweise elastische Elektrodenschicht und eine zweite vorzugsweise elastische Elektrodenschicht aufweist, die sich parallel zueinander erstrecken, wobei zwischen der ersten und der zweiten Elektrodenschicht eine erste elektroaktive Polymerschicht vorgesehen ist und wobei der erste elektroaktive Polymeraktuator derart ausgebildet ist, dass ein Anlegen einer elektrischen Spannung zwischen der ersten und der zweiten Elektrodenschicht zu einer Änderung der Abmessung der ersten elektroaktiven Polymerschicht parallel zu der ersten und zweiten Elektrodenschicht führt. In bevorzugter Weise ist der erste elektroaktive Polymeraktuator derart ausgebildet, dass sich die Abmessungen der ersten elektroaktiven Polymerschicht parallel zu der ersten und zweiten Elektrodenschicht vergrößern, wenn eine elektrische Spannung zwischen der ersten und der zweiten Elektrodenschicht angelegt wird. In einer bevorzugten Ausführungsform kann es sich bei dem elektroaktiven Polymer der ersten Polymerschicht insbesondere um ein elektroaktives dielektrisches Elastomer handeln.

Der erste elektroaktive Polymeraktuator ermöglicht, dass in einfacher Weise ohne aufwendige Mechanik ein Element geschaffen wird, dessen Abmessung bereits dann geändert werden, wenn eine elektrische Spannung mit einer vorgegebenen Höhe zwischen den beiden Elektrodenschichten angelegt wird. Darüber hinaus lässt sich ein solcher elektroaktiver Polymeraktuator einfach herstellen. Als elektroaktives Polymer kann dabei insbesondere Silikon, ggf. in Verbindung mit einem Füllmaterial, verwendet werden.

Schließlich ist das erfindungsgemäße Befestigungselement derart ausgestaltet, dass das erste und das zweite Verriegelungselement in der Verriegelungsstellung sind, wenn zwischen der ersten und der zweiten Elektrodenschicht keine elektrische Spannung angelegt ist und wobei das erste und das zweite Verriegelungselement relativ zueinander in die Lösestellung verschwenkt werden, wenn eine elektrische Spannung zwischen der ersten und der zweiten Elektrodenschicht angelegt wird.

Erfindungsgemäß kann somit durch Anlegen einer Spannung in einer vorgegebenen Höhe erreicht werden, dass die Verriegelungselemente relativ zueinander verschwenkt werden und die Lösestellung einnehmen. Die relative Schwenkbewegung kann erfindungsgemäß dadurch erreicht werden, dass nur eines der beiden Verriegelungselemente eine Schwenkbewegung, beispielsweise relativ zu dem Basisteil ausführt. Es ist aber auch möglich, dass beide Verriegelungselemente relativ zu dem Basisteil verschwenkt werden.

Erfindungsgemäß kann die Befestigungsanordnung durch Überführen des Befestigungselements von der Lösestellung in die Verriegelungsstellung, indem die Spannung zwischen den Elektrodenschichten abgeschaltet wird, einfach in die Eingriffsstellung verbracht werden, ohne dass große Belastungen auf beteiligte Bauteile ausgeübt werden, wie dies beispielsweise beim Anziehen einer Schraubverbindung der Fall ist. Vielmehr wird die Rückstellkraft des elektroaktiven Polymeraktuators ausgenutzt, um eine Anpresskraft zu erzeugen. Außerdem kann die erfindungsgemäße Befestigungsanordnung auch einfach wieder gelöst werden, indem lediglich eine Spannung zwischen den Elektrodenschichten angelegt wird. Auch hier ist es nicht erforderlich, große Kräfte aufzubringen. Außerdem muss auch kein Teil der erfindungsgemäßen Befestigungsanordnung zerstört werden.

In einer bevorzugten Ausführungsform der erfindungsgemäßen Befestigungsanordnung weist das Basisteil eine Kante aufweist, die sich von der ersten zu der zweiten Elektrodenschicht erstreckt, wobei das erste Verriegelungselement und das zweite Verriegelungselement einander gegenüberliegend an der Kante befestigt sind, wobei das erste Verriegelungselement auf einer ersten Seite einer sich mittig und parallel zu ersten und zweiten Elektrodenschicht durch die Polymerschicht erstreckenden Mittelebene an der Kante angebracht ist und wobei das zweite Verriegelungselement auf einer zweiten Seite der Mittelebene angebracht ist.

Bei dieser Ausführungsform sind die Verriegelungselement an einer Kante am Basisteil angebracht, wobei die Kante so am Basisteil verläuft, dass sie sich zwischen der ersten und der zweiten Elektrodenschicht, die parallel zueinander verlaufen, erstreckt. Die Kante verbindet also die Elektrodenschichten miteinander. Das erste Verriegelungselement ist bei dieser Ausführungsform auf der einen Seite einer durch die erste Polymerschicht verlaufende Mittelebene angeordnet, während das zweite Verriegelungselement auf der anderen Seite angebracht ist. Dabei liegen sich die Verriegelungselemente aber einander gegenüber.

Wenn bei dieser Ausführungsform eine Spannung mit der vorgegebenen Höhe zwischen der ersten und der zweiten Elektrodenschicht angelegt wird, vergrößert sich vorzugsweise die Abmessung der Polymerschicht parallel zu den Elektrodenschichten. Dadurch werden die an der Kante befestigten Verriegelungsarme auseinander geschwenkt und nehmen die Lösestellung ein. In der Verriegelungsstellung, in der bei dieser Ausführungsform die Verriegelungsarme zueinander hin geschwenkt sind, können diese mit einem Gegenstück eingreifen, das zwischen den Verriegelungsarmen angeordnet ist, während das Gegenstück freigegeben wird, wenn die Verriegelungsarme wie beschrieben auseinander schwenken und die Lösestellung einnehmen.

Hierbei ist es weiter bevorzugt, wenn das Befestigungselement derart ausgestaltet ist, dass das erste Verriegelungselement und das zweite Verriegelungselement voneinander weg in die Lösestellung schwenken, wenn eine elektrische Spannung zwischen der ersten und der zweiten Elektrodenschicht angelegt wird.

Insbesondere kann bei dieser Ausführungsform das erste Verriegelungselement an der Kante auf Höhe der ersten Elektrodenschicht angeordnet sein, wobei das zweite Verriegelungselement an der Kante auf Höhe der zweiten Elektrodenschicht angeordnet ist. Bei einer derartigen Anordnung wird schon einer vergleichsweise geringen Änderung der Abmessung der Polymerschicht ein großer Schwenkwinkel der Verriegelungselemente bewirkt, wenn die Elektrodenschichten mit einer Spannung beaufschlagt werden.

In weiter bevorzugter Weise kann das Befestigungselement derart ausgebildet sein, dass das erste Verriegelungselement und das zweite Verriegelungselement relativ zu dem Basisteil und voneinander weg schwenken, wenn eine elektrische Spannung zwischen der ersten und der zweiten Elektrodenschicht angelegt wird. Bei dieser Ausführungsform findet also eine Schwenkbewegung beider Verriegelungselement relativ zu der Basis statt.

Weiterhin ist es bevorzugt, wenn die Verriegelungselemente zueinander weisende Eingriffsvorsprünge aufweisen, wobei die Befestigungsanordnung ein Gegenstück umfasst, das einen Hauptkörper und einen sich davon entlang einer Erstreckungsrichtung weg erstreckenden Vorsprung aufweist, wobei der Vorsprung einander gegenüberliegende Seitenflächen aufweist, die sich von dem Hauptkörper hin zu einem freien Ende des Vorsprungs erstecken, und wobei in den Seitenflächen Aussparungen zum Eingriff mit den Eingriffsvorsprüngen vorgesehen sind.

Bei diesem Aufbau der Befestigungsanordnung können die Verriegelungselemente mit den daran vorgesehen Eingriffsvorsprüngen mit Aussparungen in den Seitenflächen des Vorsprungs eingreifen, sodass in einfacher Weise Zugkräfte in Richtung der Erstreckungsrichtung des Vorsprungs übertragen werden können.

In einer weiteren bevorzugten Ausführungsform weist das Basisteil einen Basiskörper auf, der eine erste und eine zweite Seitenfläche hat, die einander gegenüberliegend an dem Basiskörper angeordnet sind und sich parallel zu einer Längsachse des Basiskörpers erstrecken. Weiterhin weist das Basisteil einen zweiten elektroaktiven Polymeraktuator auf, wobei der zweite elektroaktive Polymeraktuator eine dritte Elektrodenschicht und eine vierte Elektrodenschicht aufweist, die sich parallel zueinander erstrecken, wobei zwischen der dritten und der vierten Elektrodenschicht des zweiten elektroaktive Polymeraktuators eine zweite elektroaktive Polymerschicht vorgesehen ist, wobei der zweite elektroaktive Polymeraktuator derart ausgebildet ist, dass ein Anlegen einer elektrischen Spannung zwischen der dritten und der vierten Elektrodenschicht zu einer Änderung der Abmessung der zweiten elektroaktiven Polymerschicht parallel zu der dritten und vierten Elektrodenschicht führt, wobei die erste Elektrodenschicht des ersten elektroaktiven Polymeraktuators an der ersten Seitenfläche des Basiskörpers befestigt ist und die erste elektroaktive Polymerschicht auf der von dem Basiskörper abgewandten Seite der ersten Elektrodenschicht angeordnet ist, und wobei die dritte Elektrodenschicht des zweiten elektroaktiven Polymeraktuators an der zweiten Seitenfläche des Basiskörpers befestigt ist und die zweite elektroaktive Polymerschicht auf der von dem Basiskörper abgewandten Seite der dritten Elektrodenschicht angeordnet ist. In einer bevorzugten Ausführungsform kann es sich bei dem elektroaktiven Polymer der zweiten Polymerschicht auch um ein elektroaktives dielektrisches Elastomer handeln.

Bei dieser Ausführungsform sind demnach auf einander gegenüberliegenden Seiten eines Basiskörpers jeweils elektroaktive Polymeraktuatoren angebracht.

Weiterhin sind bei dieser Ausführungsform der erste und der zweite elektroaktive Polymeraktuator derart ausgebildet, dass sich die Abmessungen der ersten und zweiten elektroaktiven Polymerschicht parallel zu den Elektrodenschichten vergrößern, wenn eine elektrische Spannung zwischen der ersten und der zweiten sowie zwischen der dritten und vierten Elektrodenschicht angelegt wird

Ferner weist das Basisteil eine Kante auf, die sich von der zweiten zu der vierten Elektrodenschicht erstreckt, wobei das erste Verriegelungselement und das zweite Verriegelungselement einander gegenüberliegend an der Kante befestigt sind, wobei das erste Verriegelungselement auf einer ersten Seite einer sich mittig und parallel zu den Elektrodenschichten durch den Basiskörper erstreckenden Mittelebene an der Kante angebracht ist und wobei das zweite Verriegelungselement auf einer zweiten Seite der Mittelebene angebracht ist.

Außerdem sind das erste und das zweite Verriegelungselement derart an der Kante gehaltert, dass sie sich unter einem Winkel zu der Längsachse und über den Querschnitt des Basisköpers mit den elektroaktiven Polymeraktuatoren senkrecht zu der Längsachse hinaus erstrecken, wenn zwischen der ersten und der zweiten Elektrodenschicht und zwischen der dritten und der vierten Elektrodenschicht keine Spannung anliegt.

Dies bedeutet, dass dann, wenn die Verriegelungselemente in der Verriegelungsstellung sind, sich diese über den Querschnitt des Basisköpers mit den Polymeraktuatoren hinaus erstrecken. Wenn das Befestigungselement gemäß dieser Ausführungsform in der Weise in eine Bohrung in einem Bauteil eingefügt ist, dass die Verriegelungselemente über die Bohrung vorstehen, können diese zur Anlage mit der Fläche des Bauteils gelangen, die die Bohrung umgibt. So können sie verhindern, dass das Befestigungselement von der Fläche, an der die Verriegelungselemente anliegen, weg durch die Bohrung hindurch gezogen wird.

Das Befestigungselement gemäß dieser Ausführungsform ist ferner so ausgestaltet, dass das erste Verriegelungselement derart an der Kante gehaltert ist, dass es derart hin zu dem zweiten Verriegelungselement verschwenkt wird, dass es sich nicht über den Querschnitt des Basisköpers mit den elektroaktiven Polymeraktuatoren senkrecht zu der Längsachse hinaus erstreckt, wenn zwischen der ersten und der zweiten Elektrodenschicht eine vorgegebene Spannung anliegt. Außerdem ist das zweite Verriegelungselement derart an der Kante gehaltert ist, dass es derart hin zu dem ersten Verriegelungselement verschwenkt wird, dass es sich nicht über den Querschnitt des Basisköpers mit den elektroaktiven Polymeraktuatoren senkrecht zu der Längsachse hinaus erstreckt, wenn zwischen der dritten und der vierten Elektrodenschicht eine vorgegebene Spannung anliegt.

Daher werden bei dieser Ausführungsform die Verriegelungselemente, wenn die Elektrodenschichten mit einer Spannung beaufschlagt werden, so weit zusammengeschwenkt, dass sie nicht mehr über den Querschnitt des Basiskörpers mit den Polymeraktuatoren hervorstehen. Dadurch hat das gesamte Befestigungselement einen Querschnitt, der durch den des Basiskörpers und der Verriegelungselemente bestimmt wird. Wenn, wie bereits zuvor beschrieben, das Befestigungselement in eine Bohrung in einem Bauteil eingesetzt ist und die Verriegelungselemente in deren Verriegelungsstellung an einer Fläche des Bauteils anliegen, kann das Befestigungselement, wenn die Verriegelungselemente durch Anlegen einer Spannung an die Elektrodenschichten in die Lösestellung verbrachte worden sind, durch die Bohrung herausgezogen werden. Genauso ist es möglich, dass das Befestigungselement, wenn die Verriegelungselemente in der Lösestellung sind, in eine Bohrung eingeschoben wird. Anschließend kann die Spannung abgeschaltet werden, sodass die Verriegelungselemente in die Verriegelungsstellung schwenken und zur Anlage mit einer Fläche an dem Bauteil kommen können, die die Bohrung umgibt. Dies verhindert dann, dass das Befestigungselement wieder aus der Bohrung herausgezogen werden kann. Damit kann diese Ausführungsform dazu verwendet werden, Bauteile an einer Bohrung in einem weiteren Bauteil zu haltern.

In einer anderen bevorzugten Ausführungsform kann vorgesehen sein, dass das Basisteil einen Basiskörper aufweist, wobei das erste und das zweite Verriegelungselement einander gegenüber liegend fest mit dem Basiskörper verbunden sind. Der erste elektroaktive Polymeraktuator ist zwischen dem ersten und dem zweiten Verriegelungselement angeordnet, wobei die erste Elektrodenschicht an dem Basiskörper befestigt ist und die erste elektroaktive Polymerschicht auf der von dem Basiskörper abgewandten Seite der ersten Elektrodenschicht angeordnet ist, wobei der Basiskörper elastisch verformbar ist und das erste und das zweite Verriegelungselement in der Verriegelungsstellung sind, wenn der Basiskörper unverformt ist. Schließlich wird der Basiskörper elastisch verformt und das erste und zweite Verriegelungselement nehmen die Lösestellung ein, wenn eine elektrische Spannung zwischen der ersten und der zweiten Elektrodenschicht angelegt wird.

Insbesondere kann das Befestigungselement derart ausgestaltet sein, dass das erste und das zweite Verriegelungselement, wenn der Basiskörper elastisch verformt wird, damit das erste und zweite Verriegelungselement die Lösestellung einnehmen, voneinander weg schwenken.

Diese Ausführungsform kann insbesondere dafür verwendet werden, um zwischen den Verriegelungselementen Rohre oder Kabel aufzunehmen und diese zu haltern. Außerdem ist es möglich, dass zwei Befestigungselemente dieser Ausführungsform mit einander fest gekoppelt werden, wenn die Verriegelungselemente in die Verriegelungsstellung verschwenkt werden.

Nachfolgend wird die vorliegende Erfindung anhand einer lediglich bevorzugte Ausführungsbeispiele zeigenden Zeichnung erläutert, wobei
- Fig. 1: eine schematische Darstellung eines ersten Ausführungsbeispiels einer erfindungsgemäßen Befestigungsanordnung ist,
- Fig. 2: eine schematische Darstellung der Funktionsweise der elektroaktiven Polymeraktuatoren ist, die bei den erfindungsgemäßen Befestigungsanordnungen verwendet werden können,
- Fig. 3: eine schematische Darstellung eines zweiten Ausführungsbeispiels einer erfindungsgemäßen Befestigungsanordnung ist,
- Fig. 4: eine schematische Darstellung eines dritten Ausführungsbeispiels einer erfindungsgemäßen Befestigungsanordnung ist und
- Fig. 5: eine schematische Darstellung eines vierten Ausführungsbeispiels einer erfindungsgemäßen Befestigungsanordnung ist.

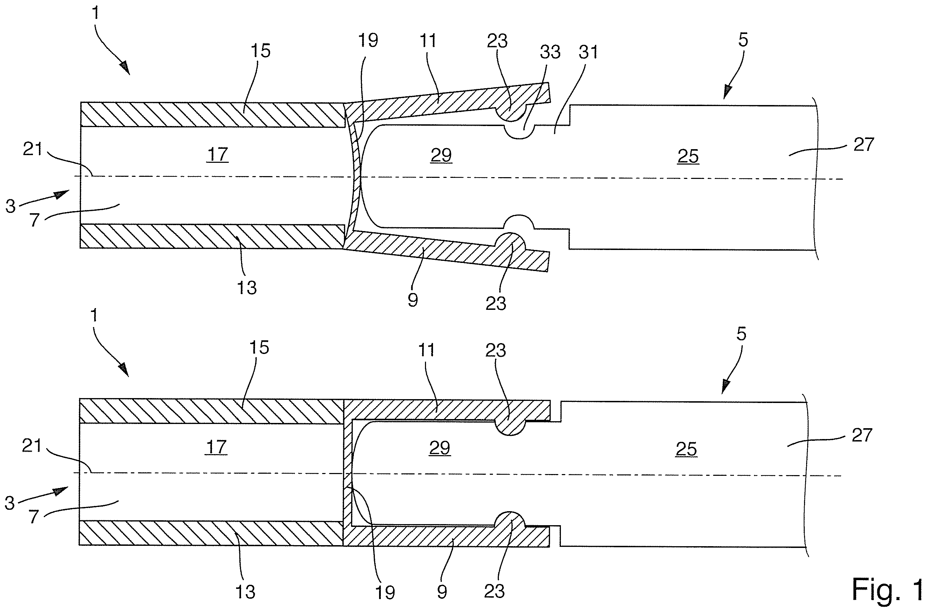

Fig. 1 zeigt ein erstes Ausführungsbeispiel einer erfindungsgemäßen Befestigungsanordnung 1, wobei im oberen Teil die Verriegelungselemente in der Lösestellung sind und im unteren Teil in der Verriegelungsstellung.

Das erste Ausführungsbeispiel einer erfindungsgemäßen Befestigungsanordnung 1 umfasst ein Befestigungselement 3 und ein Gegenstück 5.

Das Befestigungselement 1 wiederum weist ein Basisteil 7 auf, an dem wiederum ein erstes Verriegelungselement 9 und ein zweites Verriegelungselement 11 vorgesehen sind. Das erste und das zweite Verriegelungselement 9, 11 sind an dem Basisteil befestigt und können eine Verriegelungsstellung (in Fig. 1 im unteren Teil) und eine Lösestellung (in Fig. 1 im oberen Teil) einnehmen. Insbesondere können die beiden Verriegelungselemente 9, 11 in diesem Ausführungsbeispiel nicht nur relativ zueinander, sondern beide auch relativ zu dem Basiselement 7 schwenken.

In dem hier beschriebenen ersten Ausführungsbeispiel ist das Basisteil 7 als ein erster elektroaktiver Polymeraktuator ausgebildet. Dieser weist eine vorzugsweise elastische erste Elektrodenschicht 13 und eine vorzugsweise elastische zweite Elektrodenschicht 15 auf, die sich parallel zueinander erstrecken. Zwischen der ersten und der zweiten Elektrodenschicht 13, 15 ist eine erste elektroaktive Polymerschicht 17 vorgesehen, wobei der erste elektroaktive Polymeraktuator derart ausgebildet ist, dass ein Anlegen einer vorgegebenen elektrischen Spannung zwischen der ersten und der zweiten Elektrodenschicht 13, 15 zu einer Änderung der Abmessung der ersten elektroaktiven Polymerschicht 17 parallel zu der ersten und zweiten Elektrodenschicht 13, 15 führt. Insbesondere vergrößern sich bei dem hier gezeigten Ausführungsbeispielen die Abmessungen der ersten elektroaktiven Polymerschicht 17 parallel zu der ersten und zweiten Elektrodenschicht 13, 15, wenn eine elektrische Spannung zwischen der ersten und der zweiten Elektrodenschicht 13, 15 angelegt wird. Bei dem elektroaktiven Polymer der ersten Polymerschicht 17 kann es sich insbesondere um ein elektroaktives dielektrisches Elastomer handeln.

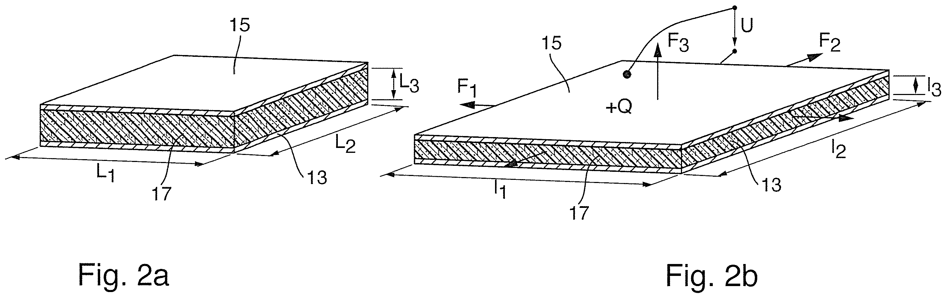

In Fig. 2 ist noch einmal schematisch die Funktionsweise eines elektroaktiven Polymeraktuators dargestellt. In dem in Teil a) von Fig. 2 gezeigten Zustand liegt keine Spannung zwischen den elastischen Elektrodenschichten 13, 15 an, und die elektroaktive Polymerschicht hat die mit L1, L2 und L3 bezeichneten Abmessungen. Wenn jedoch eine Spannung einer vorgegebenen Höhe zwischen den Elektrodenschichten 13, 15 anliegt, verändern sich die Abmessungen der Polymerschicht 17 parallel zu den Elektrodenschichten 13, 15. Insbesondere nimmt der Abstand zwischen den Elektrodenschichten 13, 15 von L3 auf l3 ab, während sich Abmessungen parallel zu den Elektrodenschichten 13, 15 vergrößern, d.h. L1 vergrößert sich aufl1 und L2 vergrößert sich aufl2. Diese Vergrößerung wird in Fig. 2 durch die mit F1 und F2 bezeichneten Pfeile wiedergegeben. Wenn die Spannung zwischen den Elektrodenschichten 13, 15 wieder abgeschaltet wird, kehrt der Aktuator wieder in die in Teil a) von Fig. 2 gezeigte Stellung zurück, d.h. l3 vergrößert sich wieder auf L3, während l1 sich auf L1 verringert und l2 auf L2. Erfindungsgemäß werden derartige Aktuatoren in der im Folgenden beschriebenen Weise verwendet, um die Verriegelungselemente 11, 13 zwischen der Lösestellung der Verriegelungsstellung zu bewegen. Dabei wird ausgenutzt, dass derartige Aktuatoren erhebliche Kräfte aufbringen können, und zwar sowohl, dann wenn eine Spannung an die Elektrodenschichten angelegt wird, als auch dann, wenn diese abgeschaltet wird und die Polymerschicht in die Ausgangsstellung zurückkehrt.

Wie weiter aus Fig. 1 hervorgeht, ist das Befestigungselement derart ausgestaltet, dass das erste und das zweite Verriegelungselement 9, 11 in der Verriegelungsstellung sind, wenn zwischen der ersten und der zweiten Elektrodenschicht 13, 15 keine elektrische Spannung angelegt ist. Wenn hingegen eine elektrische Spannung zwischen der ersten und der zweiten Elektrodenschicht 13, 15 angelegt wird, schwenken das erste und das zweite Verriegelungselement 9, 11 relativ zueinander in die Lösestellung. Bei dem ersten in Fig. 1 gezeigten Ausführungsbeispiel wird dies durch folgenden Aufbau erreicht, wobei aber auch andere Konfigurationen denkbar sind.

Bei dem ersten in Fig. 1 gezeigten Ausführungsbeispiel weist der das Basisteil 7 bildende Polymeraktuator eine Kante 19 auf, die sich von der ersten zu der zweiten Elektrodenschicht 13, 15 erstreckt, wobei das erste Verriegelungselement 9 und das zweite Verriegelungselement 11 einander gegenüberliegend an der Kante 9 befestigt sind. Letzteres bedeutet, dass in der Ebene der Elektrodenschichten 13, 15 betrachtet, die Verriegelungselemente 9, 11 an derselben Position sind.

Dabei ist das erste Verriegelungselement 9 auf einer ersten Seite einer sich mittig und parallel zu ersten und zweiten Elektrodenschicht 13, 15 durch die erste Polymerschicht 17 erstreckenden Mittelebene 21 an der Kante 19 angebracht ist, während das zweite Verriegelungselement 11 auf einer zweiten Seite der Mittelebene 21 angebracht ist. Insbesondere ist das erste Verriegelungselement 9 an der Kante 19 auf Höhe der ersten Elektrodenschicht 13 angeordnet ist und das zweite Verriegelungselement 11 ist an der Kante 19 auf Höhe der zweiten Elektrodenschicht 15 angeordnet.

Wenn eine elektrische Spannung zwischen der ersten und der zweiten Elektrodenschicht 13, 15 angelegt wird, vergrößert sich die Abmessungen der ersten Polymerschicht 17 parallel zu der ersten und zweiten Elektrodenschicht 13, 15, wie dies im oberen Teil von Fig. 1 zu erkennen ist. Dadurch schwenken das erste Verriegelungselement 9 und das zweite Verriegelungselement 11 voneinander weg in die Lösestellung. Insbesondere ist das Befestigungselement 3 derart ausgebildet, dass das erste Verriegelungselement 9 und das zweite Verriegelungselement 11 relativ zu dem das Basisteil 7 bildenden elektroaktiven Aktuator und auch voneinander weg schwenken, wenn eine elektrische Spannung zwischen der ersten und der zweiten Elektrodenschicht 13, 15 angelegt wird.

Weiterhin ist in Fig. 1 zu erkennen, dass die Verriegelungselemente 9, 11 zueinander weisende Eingriffsvorsprünge 23 aufweisen. Darüber hinaus umfasst die Befestigungsanordnung 1 ein Gegenstück 5, das einen Hauptkörper 25 und einen sich davon entlang einer Erstreckungsrichtung 27 weg erstreckenden Vorsprung 29 aufweist. An dem Vorsprung 29 wiederum sind einander gegenüberliegende Seitenflächen 31 vorgesehen, die sich von dem Hauptkörper 25 hin zu einem freien Ende des Vorsprungs 29 erstecken, und in den Seitenflächen 31 sind Aussparungen 33 zum Eingriff mit den Eingriffsvorsprüngen 23 vorgesehen.

Das Ausführungsbeispiel einer Befestigungsanordnung 1, das in Fig. 1 gezeigt ist, kann wie folgt in Eingriff gebracht werden. Zunächst wird an die Elektrodenschichten 13, 15 eine Spannung angelegt, sodass die Verriegelungselemente 9, 11 in die Lösestellung schwenken, die in Fig. 1 oben gezeigt ist. Dann kann das Befestigungselement 3 auf das Gegenstück 5 so aufgeschoben werden, dass der Vorsprung 29 zwischen den Verriegelungsarmen 9, 11 angeordnet ist. Anschließend wird die Spannung zwischen den Elektrodenschichten 13, 15 abgeschaltet, sodass die Verriegelungsarme 9, 11 zurück in die Verriegelungsstellung schwenken und die Eingriffsvorsprünge 23 mit den Aussparungen 33 eingreifen. In dieser verriegelten Stellung kann die Befestigungsanordnung 1 Zugkräfte übertragen. Zum Lösen der Befestigungsanordnung muss lediglich wieder eine Spannung zwischen den Elektrodenschichten 13, 15 angelegt werden.

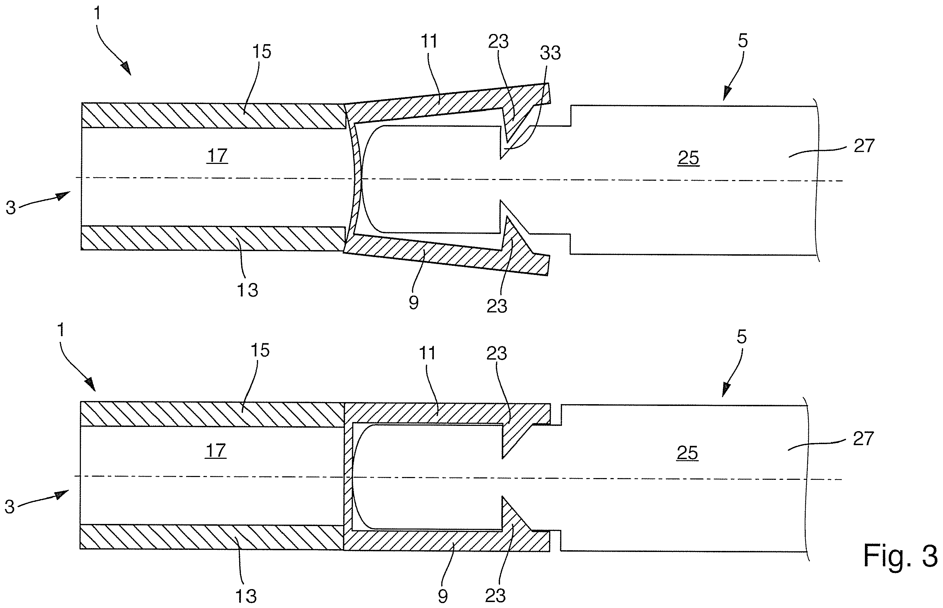

Das in Fig. 3 gezeigte zweite bevorzugte Ausführungsbeispiel einer erfindungsgemäßen Befestigungsanordnung 1 unterscheidet von in Fig. 1 gezeigten lediglich dadurch, dass die Eingriffsvorsprünge 23 eine andere Querschnittsform haben als die aus dem ersten Ausführungsbeispiel. Entsprechend haben auch die Aussparungen 33 eine andere Form.

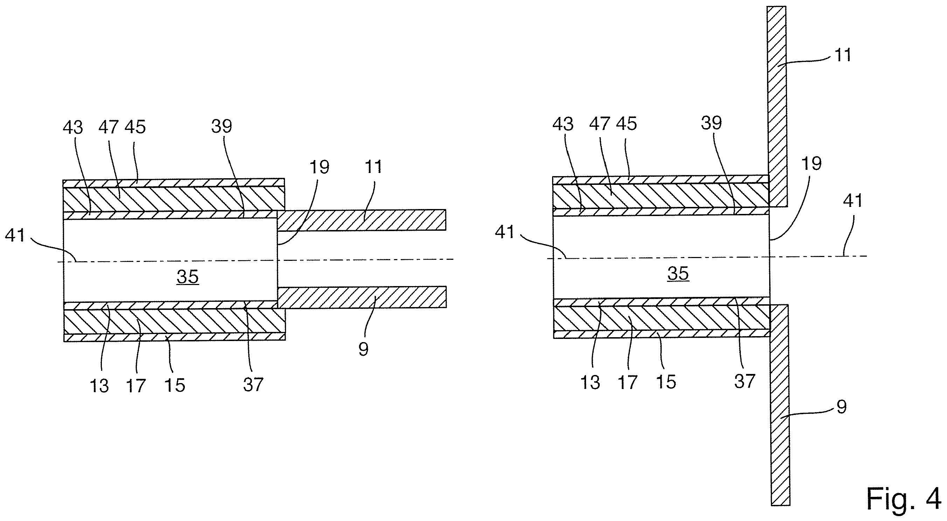

In Fig. 4 ist ein drittes Ausführungsbeispiel einer erfindungsgemäßen Befestigungsanordnung 1 gezeigt. Die Befestigungsanordnung 1 weist ein Befestigungselement 3 auf, das wiederum ein Basisteil 7 umfasst.

Das Basisteil 7 weist eine Basiskörper 35 auf, der eine erste und eine zweite Seitenfläche 37, 39 hat, die einander gegenüberliegend an dem Basiskörper 35 angeordnet sind und sich parallel zu einer Längsachse 41 des Basiskörpers 35 erstrecken. Auch bei diesem Ausführungsbeispiel ist ein erster elektroaktiver Polymeraktuator vorgesehen, der eine erste Elektrodenschicht 13 und eine zweite Elektrodenschicht 15 aufweist, die sich parallel zueinander erstrecken, wobei zwischen der ersten und der zweiten Elektrodenschicht 13, 15 eine erste elektroaktive Polymerschicht 17 vorgesehen ist. Die erste Elektrodenschicht 13 des ersten elektroaktiven Polymeraktuators ist an der ersten Seitenfläche 37 des Basiskörpers 35 befestigt und die erste elektroaktive Polymerschicht 17 ist auf der von dem Basiskörper 35 abgewandten Seite der ersten Elektrodenschicht 13 angeordnet.

Außerdem ist bei diesem Ausführungsbeispiel an dem Basisteil ein zweiter elektroaktiver Polymeraktuator vorgesehen, wobei der zweite elektroaktive Polymeraktuator eine dritte Elektrodenschicht 43 und eine vierte Elektrodenschicht 45 aufweist, die sich parallel zueinander erstrecken und wobei zwischen der dritten und der vierten Elektrodenschicht 43, 45 des zweiten elektroaktive Polymeraktuators eine zweite elektroaktive Polymerschicht 47 vorgesehen ist. Auch bei dem elektroaktiven Polymer der zweiten Polymerschicht 47 kann es sich insbesondere um ein elektroaktives dielektrisches Elastomer handeln.

Die dritte Elektrodenschicht 43 des zweiten elektroaktiven Polymeraktuators ist an der zweiten Seitenfläche 39 des Basiskörpers 35 befestigt, und die zweite elektroaktive Polymerschicht 47 ist auf der von dem Basiskörper 35 abgewandten Seite der dritten Elektrodenschicht 43 angeordnet ist.

Sowohl der erste als auch der zweite elektroaktive Polymeraktuator sind von der Funktionsweise so ausgebildet, wie dies bereits im Zusammenhang mit Fig. 2 erläutert worden ist. Insbesondere sind der erste und der zweite elektroaktive Polymeraktuator derart ausgebildet, dass sich die Abmessungen der ersten und zweiten elektroaktiven Polymerschicht 17, 47 parallel zu den Elektrodenschichten 13, 15, 43, 45 vergrößern, wenn eine elektrische Spannung zwischen der ersten und der zweiten sowie zwischen der dritten und vierten Elektrodenschicht angelegt wird.

An dem Basisteil 35 ist zudem eine Kante 19 vorgesehen, die sich von der zweiten zu der vierten Elektrodenschicht 13, 45 erstreckt, wobei das erste Verriegelungselement 9 und das zweite Verriegelungselement 11 einander gegenüberliegend an der Kante 19 befestigt sind. Das erste Verriegelungselement 9 ist auf einer ersten Seite einer sich mittig und parallel zu den Elektrodenschichten 13, 15, 43, 45 durch den Basiskörper 5 erstreckenden Mittelebene 21 an der Kante 19 angebracht, während das zweite Verriegelungselement 11 auf einer zweiten Seite der Mittelebene 21 angebracht ist.

Wie weiter aus dem rechten Teil von Fig. 4 zu erkennen ist, sind das erste und das zweite Verriegelungselement 9, 11 derart an der Kante 19 gehaltert sind, dass sie sich unter einem Winkel zu der Längsachse 41 und über den Querschnitt des Basisköpers 35 mit den elektroaktiven Polymeraktuatoren senkrecht zu der Längsachse 41 hinaus erstrecken, wenn zwischen der ersten und der zweiten Elektrodenschicht 13, 15 und zwischen der dritten und der vierten Elektrodenschicht 43, 45 keine Spannung anliegt, sodass die Verriegelungselemente 9, 11 in der Verriegelungsstellung sind. Insbesondere kann der Winkel zwischen den Verriegelungselementen 180° betragen, sodass die Verriegelungselemente senkrecht zu der Längsachse 41 des Basisköpers verlaufen.

Wenn zwischen der ersten und der zweiten Elektrodenschicht 13, 15 eine vorgegebene Spannung anliegt, wird das erste Verriegelungselement 9 so hin zu dem zweiten Verriegelungselement 11 verschwenkt wird, dass es sich nicht über den Querschnitt des Basisköpers 35 mit den elektroaktiven Polymeraktuatoren senkrecht zu der Längsachse 41 hinaus erstreckt. Dies ist im linken Teil von Fig. 4 zu erkennen. Genauso wird das zweite Verriegelungselement 11 so hin zu dem ersten Verriegelungselement 9 verschwenkt, dass es sich nicht über den Querschnitt des Basisköpers 35 mit den elektroaktiven Polymeraktuatoren senkrecht zu der Längsachse 41 hinaus erstreckt, wenn zwischen der dritten und der vierten Elektrodenschicht 43, 45 eine vorgegebene Spannung anliegt.

Dieses Ausführungsbeispiel kann in der folgenden Weise verwendet werden, um an einem Bauteil angebracht zu werden, das eine Bohrung aufweist. Zunächst wird zwischen den ersten und zweiten Elektrodenschichten 13, 15 sowie zwischen den dritten und vierten Elektrodenschichten 43, 45 eine Spannung angelegt. Dies bewirkt, dass die beiden Verriegelungselemente 9, 11 zueinander hin verschwenkt werden und sie sich nicht mehr senkrecht zu der Längsachse 41 über den Querschnitt des Basiskörper 35 hinaus erstrecken. Dann kann das Befestigungselement 1 in die Bohrung eingeschoben werden, bis sich die Kante 19 wenigstens in der Ebene der von der Einführseite abgewandten Fläche des Bauteils befindet. Anschließend wird die Spannung zwischen den Elektrodenschichten 13, 15, 43, 45 abgeschaltet, und die Verriegelungselemente 9, 11 schwenken auseinander und nehmen die in Fig. 4 rechts gezeigte Stellung ein. Dadurch wird das Befestigungselement 1 daran gehindert, aus der Bohrung herausgezogen zu werden. Wenn das Befestigungselement 1 aus der Bohrung gelöst werden soll, ist es lediglich erforderlich, dass zwischen der ersten und der zweiten Elektrodenschicht 13, 15 sowie zwischen der dritten und der vierten Elektrodenschicht 43, 45 eine Spannung angelegt wird, sodass die Verriegelungselemente 9, 11 wieder zueinander schwenken. Dann verhindern die Verriegelungselemente 9, 11 nicht mehr, dass das Befestigungselement 1 aus der Bohrung gezogen wird.

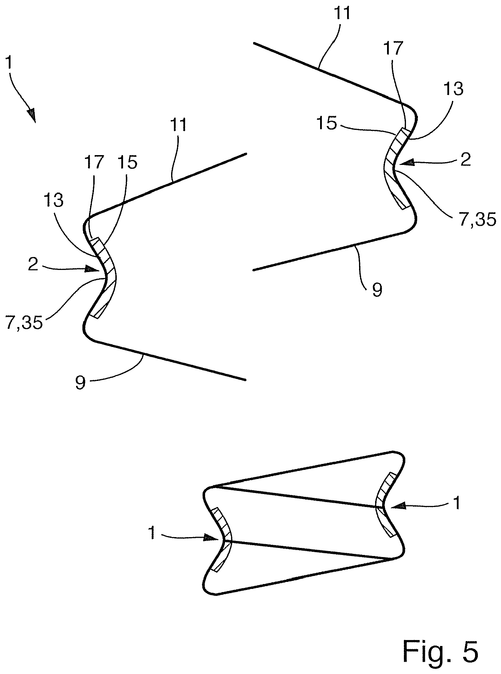

In Fig. 5 ist ein viertes Ausführungsbeispiel einer erfindungsgemäßen Befestigungsanordnung 1 gezeigt. Bei diesem Ausführungsbeispiel weist das Basisteil 7 einen Basiskörper 35 auf, wobei das erste und das zweite Verriegelungselement 9, 11 einander gegenüber liegend fest mit dem Basiskörper 35 verbunden sind. Es liegt also eine starre Verbindung zwischen dem Basiskörper 35 und den Verriegelungselementen 9, 11 vor. Bei dieser Ausführungsform ist der erste elektroaktive Polymeraktuator zwischen dem ersten und dem zweiten Verriegelungselement 9, 11 an dem Basiskörper 35 angeordnet ist, wobei die erste Elektrodenschicht 13 an dem Basiskörper 35 befestigt ist und die erste elektroaktive Polymerschicht 17 auf der von dem Basiskörper 35 abgewandten Seite der ersten Elektrodenschicht 15 angeordnet ist. Die zweite Elektrodenschicht 15 wiederum ist auf der Seite der Polymerschicht 17 angeordnet, die von dem Basiskörper 35 entfernt ist.

Bei diesem Ausführungsbeispiel ist der Basiskörper 35 elastisch verformbar ist und das erste und das zweite Verriegelungselement sind in der Verriegelungsstellung sind, wenn der Basiskörper unverformt ist. Der Basiskörper 35 wird jedoch elastisch verformt und das erste und zweite Verriegelungselement nehmen die Lösestellung ein, wenn eine elektrische Spannung zwischen der ersten und der zweiten Elektrodenschicht 13, 15 angelegt wird. Dann dehnt sich die Polymerschicht 17 parallel zu die Elektrodenschichten 13, 15 aus, sodass die Verriegelungselemente 9, 11 deswegen von einander weg schwenken, weil die Polymerschicht 17 über die erste Elektrodenschicht 13 fest mit dem Basiskörper 35 verbunden ist und dieser durch die Längenänderung gebogen wird.

Diese vierte Ausführungsform kann insbesondere dafür verwendet werden, um zwischen den Verriegelungselementen 9, 11 Rohre oder Kabel aufzunehmen und diese zu haltern. Außerdem ist es möglich, dass zwei Befestigungselemente 1 dieser Ausführungsform, wie in Fig. 5 gezeigt mit einander fest gekoppelt werden, wenn die Verriegelungselemente 9, 11 in die Verriegelungsstellung verschwenkt werden.

### Bezugszeichenliste:

- 1: Befestigungsanordnung
- 3: Befestigungselement
- 5: Gegenstück
- 7: Basisteil
- 9: erstes Verriegelungselement
- 11: zweites Verriegelungselement
- 13: erste Elektrodenschicht
- 15: zweite Elektrodenschicht
- 17: erste elektroaktive Polymerschicht
- 19: Kante
- 21: Mittelebene
- 23: Eingriffsvorsprünge
- 25: Hauptkörper
- 27: Erstreckungsrichtung
- 29: Vorsprung
- 31: Seitenfläche
- 33: Aussparung
- 35: Basiskörper
- 37: erste Seitenfläche
- 39: zweite Seitenfläche
- 41: Längsachse
- 43: dritte Elektrodenschicht
- 45: vierte Elektrodenschicht
- 47: zweite elektroaktive Polymerschicht

## Patentansprüche

1. Befestigungsanordnung mit einem Befestigungselement (1), das ein Basisteil (7) und ein erstes Verriegelungselement (9) und ein zweites Verriegelungselement (11) aufweist,
wobei das erste und das zweite Verriegelungselement (9, 11) an dem Basisteil (7) befestigt sind und eine Verriegelungsstellung und eine Lösestellung einnehmen können,
wobei das Basisteil (7) einen ersten elektroaktiven Polymeraktuator aufweist, der eine erste Elektrodenschicht (13) und eine zweite Elektrodenschicht (15) aufweist, die sich parallel zueinander erstrecken,
wobei zwischen der ersten und der zweiten Elektrodenschicht (13, 15) eine erste elektroaktive Polymerschicht (17) vorgesehen ist,
wobei der erste elektroaktive Polymeraktuator derart ausgebildet ist, dass ein Anlegen einer vorgegebenen elektrischen Spannung zwischen der ersten und der zweiten Elektrodenschicht (13, 15) zu einer Änderung der Abmessung der ersten elektroaktiven Polymerschicht (17) parallel zu der ersten und zweiten Elektrodenschicht (13, 15) führt,
dadurch charakterisiert, dass
das Befestigungselement derart ausgestaltet ist, dass das erste und das zweite Verriegelungselement (9, 11) in der Verriegelungsstellung sind, wenn zwischen der ersten und der zweiten Elektrodenschicht (13, 15) keine elektrische Spannung angelegt ist und wobei das erste und das zweite Verriegelungselement (9, 11) relativ zueinander in die Lösestellung verschwenkt werden, wenn eine elektrische Spannung zwischen der ersten und der zweiten Elektrodenschicht (13, 15) angelegt wird.

2. Befestigungsanordnung nach Anspruch 1, wobei der erste elektroaktive Polymeraktuator derart ausgebildet ist, dass sich die Abmessungen der ersten elektroaktiven Polymerschicht (17) parallel zu der ersten und zweiten Elektrodenschicht (13, 15) vergrößern, wenn eine elektrische Spannung zwischen der ersten und der zweiten Elektrodenschicht (13, 15) angelegt wird.

3. Befestigungsanordnung nach Anspruch 1 oder 2, wobei das Basisteil eine Kante (19) aufweist, die sich von der ersten zu der zweiten Elektrodenschicht (13, 15) erstreckt,
wobei das erste Verriegelungselement (9) und das zweite Verriegelungselement (11) einander gegenüberliegend an der Kante (19) befestigt sind,
wobei das erste Verriegelungselement (9) auf einer ersten Seite einer sich mittig und parallel zu ersten und zweiten Elektrodenschicht durch die erste Polymerschicht erstreckenden Mittelebene (21) an der Kante (19) angebracht ist und
wobei das zweite Verriegelungselement (11) auf einer zweiten Seite der Mittelebene (21) angebracht ist.

4. Befestigungsanordnung nach Anspruch 3, wobei das Befestigungselement (1) derart ausgestaltet ist, dass das erste Verriegelungselement (9) und das zweite Verriegelungselement (11) voneinander weg in die Lösestellung schwenken, wenn eine elektrische Spannung zwischen der ersten und der zweiten Elektrodenschicht (13, 15) angelegt wird.

5. Befestigungsanordnung nach Anspruch 3 oder 4, wobei das erste Verriegelungselement (9) an der Kante (19) auf Höhe der ersten Elektrodenschicht (13) angeordnet ist und
wobei das zweite Verriegelungselement (11) an der Kante (19) auf Höhe der zweiten Elektrodenschicht (15) angeordnet ist.

6. Befestigungsanordnung nach einem oder mehreren der Ansprüche 3 bis 5, wobei das Befestigungselement derart ausgebildet ist, dass das erste Verriegelungselement (9) und das zweite Verriegelungselement (11) relativ zu dem Basisteil (7) und voneinander weg schwenken, wenn eine elektrische Spannung zwischen der ersten und der zweiten Elektrodenschicht (13, 15) angelegt wird.

7. Befestigungsanordnung nach einem oder mehreren der Ansprüche 3 bis 6, wobei die Verriegelungselemente (9, 11) zueinander weisende Eingriffsvorsprünge (23) aufweisen,
wobei die Befestigungsanordnung ein Gegenstück (5) umfasst, das einen Hauptkörper (25) und einen sich davon entlang einer Erstreckungsrichtung (27) weg erstreckenden Vorsprung (29) aufweist,
wobei der Vorsprung (29) einander gegenüberliegende Seitenflächen (31) aufweist, die sich von dem Hauptkörper (25) hin zu einem freien Ende des Vorsprungs erstrecken, und
wobei in den Seitenflächen Aussparungen zum Eingriff mit den Eingriffsvorsprüngen vorgesehen sind.

8. Befestigungsanordnung nach Anspruch 1, wobei das Basisteil (7) einen Basiskörper (35) aufweist, der eine erste und eine zweite Seitenfläche (37, 39) hat, die einander gegenüberliegend an dem Basiskörper (35) angeordnet sind und sich parallel zu einer Längsachse (41) des Basiskörpers (35) erstrecken,
wobei das Basisteil (7) einen zweiten elektroaktiven Polymeraktuator aufweist, wobei der zweite elektroaktive Polymeraktuator eine dritte Elektrodenschicht (43) und eine vierte Elektrodenschicht (45) aufweist, die sich parallel zueinander erstrecken,
wobei zwischen der dritten und der vierten Elektrodenschicht (43, 45) des zweiten elektroaktiven Polymeraktuators eine zweite elektroaktive Polymerschicht (47) vorgesehen ist,
wobei der zweite elektroaktive Polymeraktuator derart ausgebildet ist, dass ein Anlegen einer elektrischen Spannung zwischen der dritten und der vierten Elektrodenschicht (43, 45) zu einer Änderung der Abmessung der zweiten elektroaktiven Polymerschicht (47) parallel zu der dritten und vierten Elektrodenschicht (43, 45) führt,
wobei die erste Elektrodenschicht (13) des ersten elektroaktiven Polymeraktuators an der ersten Seitenfläche (37) des Basiskörpers (35) befestigt ist und die erste elektroaktive Polymerschicht (17) auf der von dem Basiskörper (35) abgewandten Seite der ersten Elektrodenschicht (13) angeordnet ist,
wobei die dritte Elektrodenschicht (43) des zweiten elektroaktiven Polymeraktuators an der zweiten Seitenfläche (39) des Basiskörpers (35) befestigt ist und die zweite elektroaktive Polymerschicht (47) auf der von dem Basiskörper (35) abgewandten Seite der dritten Elektrodenschicht (43) angeordnet ist,
wobei der erste und der zweite elektroaktive Polymeraktuator derart ausgebildet sind, dass sich die Abmessungen der ersten und zweiten elektroaktiven Polymerschicht (17, 47) parallel zu den Elektrodenschichten (13, 15, 43, 45) vergrößern, wenn eine elektrische Spannung zwischen der ersten und der zweiten sowie zwischen der dritten und vierten Elektrodenschicht (13, 15, 43, 45) angelegt wird
wobei das Basisteil (7) eine Kante (19) aufweist, die sich von der zweiten zu der vierten Elektrodenschicht (13, 45) erstreckt,
wobei das erste Verriegelungselement (9) und das zweite Verriegelungselement (11) einander gegenüberliegend an der Kante (19) befestigt sind,
wobei das erste Verriegelungselement (9) auf einer ersten Seite einer sich mittig und parallel zu den Elektrodenschichten (13, 15, 43, 45) durch den Basiskörper (35) erstreckenden Mittelebene (21) an der Kante (19) angebracht ist und wobei das zweite Verriegelungselement (11) auf einer zweiten Seite der Mittelebene (21) angebracht ist,
wobei das erste und das zweite Verriegelungselement (9, 11) derart an der Kante (19) gehaltert sind, dass sie sich unter einem Winkel zu der Längsachse (41) und über den Querschnitt des Basisköpers (35) mit den elektroaktiven Polymeraktuatoren senkrecht zu der Längsachse (41) hinaus erstrecken, wenn zwischen der ersten und der zweiten Elektrodenschicht (13, 15) und zwischen der dritten und der vierten Elektrodenschicht (43, 45) keine Spannung anliegt,
wobei das erste Verriegelungselement (9, 11) derart an der Kante (19) gehaltert ist, dass es derart hin zu dem zweiten Verriegelungselement (11) verschwenkt wird, dass es sich nicht über den Querschnitt des Basisköpers (35) mit den elektroaktiven Polymeraktuatoren senkrecht zu der Längsachse (41) hinaus erstreckt, wenn zwischen der ersten und der zweiten Elektrodenschicht (13, 15) eine vorgegebene Spannung anliegt, und
wobei das zweite Verriegelungselement (11) derart an der Kante (19) gehaltert ist, dass es derart hin zu dem ersten Verriegelungselement (11) verschwenkt wird, dass es sich nicht über den Querschnitt des Basisköpers (35) mit den elektroaktiven Polymeraktuatoren senkrecht zu der Längsachse (41) hinaus erstreckt, wenn zwischen der dritten und der vierten Elektrodenschicht (43, 45) eine vorgegebene Spannung anliegt.

9. Befestigungsanordnung nach Anspruch 1 oder 2, wobei das Basisteil (7) einen Basiskörper (35) aufweist, wobei das erste und das zweite Verriegelungselement (9, 11) einander gegenüber liegend fest mit dem Basiskörper (35) verbunden sind,
wobei der erste elektroaktive Polymeraktuator zwischen dem ersten und dem zweiten Verriegelungselement (9, 11) angeordnet ist,
wobei die erste Elektrodenschicht (13) an dem Basiskörper (35) befestigt ist und die erste elektroaktive Polymerschicht (17) auf der von dem Basiskörper (35) abgewandten Seite der ersten Elektrodenschicht (13) angeordnet ist,
wobei der Basiskörper (35) elastisch verformbar ist und das erste und das zweite Verriegelungselement (9, 11) in der Verriegelungsstellung sind, wenn der Basiskörper (35) unverformt ist, und
wobei der Basiskörper (35) elastisch verformt wird und das erste und zweite Verriegelungselement (9, 11) die Lösestellung einnehmen, wenn eine elektrische Spannung zwischen der ersten und der zweiten Elektrodenschicht (13, 15) angelegt wird.

10. Befestigungsanordnung nach Anspruch 9, wobei das Befestigungselement derart ausgestaltet ist, dass das erste und das zweite Verriegelungselement (9, 11), wenn der Basiskörper (35) elastisch verformt wird, damit das erste und zweite Verriegelungselement (9, 11) die Lösestellung einnehmen, voneinander weg schwenken.

## Claims

1. Fastening arrangement comprising a fastening element (1) having a base part (7) and a first locking element (9) and a second locking element (11),
wherein the first and second locking elements (9, 11) are fixed to the base part (7) and can assume a locking position and a release position,
wherein the base part (7) comprises a first electroactive polymer actuator comprising a first electrode layer (13) and a second electrode layer (15) extending parallel to each other
wherein a first electroactive polymer layer (17) is provided between the first and second electrode layers (13, 15),
wherein the first electroactive polymer actuator is configured such that application of a predetermined electrical voltage between the first and second electrode layers (13, 15) results in a change in dimension of the first electroactive polymer layer (17) parallel to the first and second electrode layers (13, 15)
**characterized in that** the fastening element is configured such that the first and second locking elements (9, 11) are in the locking position when no electrical voltage is applied between the first and second electrode layers (13, 15) and wherein the first and second locking elements (9, 11) are pivoted relative to each other to the release position when an electrical voltage is applied between the first and second electrode layers (13, 15).

2. Fastening arrangement according to claim 1, wherein the first electroactive polymer actuator is configured such that the dimensions of the first electroactive polymer layer (17) increase parallel to the first and second electrode layers (13, 15) when an electrical voltage is applied between the first and second electrode layers (13, 15).

3. Fastening arrangement according to claim 1 or 2, wherein said base member comprises an edge (19) extending from said first to said second electrode layers (13, 15),
wherein the first locking element (9) and the second locking element (11) are attached to the edge (19) opposite each other,
said first locking element (9) being attached to said edge (19) on a first side of a center plane (21) extending centrally and parallel to said first and second electrode layers through said first polymer layer, and
wherein the second locking element (11) is attached to a second side of the center plane (21).

4. Fastening arrangement according to claim 3, wherein the fastening element (1) is configured such that the first locking element (9) and the second locking element (11) pivot away from each other into the release position when an electrical voltage is applied between the first and second electrode layers (13, 15).

5. Fastening arrangement according to claim 3 or 4, wherein the first locking element (9) is arranged at the edge (19) at the level of the first electrode layer (13) and
wherein the second locking element (11) is arranged at the edge (19) at the level of the second electrode layer (15).

6. Fastening arrangement according to one or more of claims 3 to 5, wherein the fastening element is configured such that the first locking element (9) and the second locking element (11) pivot relative to the base part (7) and away from each other when an electrical voltage is applied between the first and the second electrode layers (13, 15).

7. Fastening arrangement according to one or more of claims 3 to 6, wherein the locking elements (9, 11) comprise engaging projections (23) facing each other,
wherein the fastening arrangement comprises a counterpart (5) having a main body (25) and a projection (29) extending therefrom along an extending direction (27),
said projection (29) having opposing side surfaces (31) extending from said main body (25) toward a free end of said projection, and
wherein recesses are provided in said side surfaces for engagement with said engaging projections.

8. Fastening arrangement of claim 1, wherein the base member (7) comprises a base body (35) having first and second side surfaces (37, 39) oppositely disposed on the base body (35) and extending parallel to a longitudinal axis (41) of the base body (35),
wherein the base member (7) comprises a second electroactive polymer actuator,
said second electroactive polymer actuator having a third electrode layer (43) and a fourth electrode layer (45) extending parallel to each other,
wherein a second electroactive polymer layer (47) is provided between the third and fourth electrode layers (43, 45) of the second electroactive polymer actuator,
wherein the second electroactive polymer actuator is configured such that application of an electrical voltage between the third and fourth electrode layers (43, 45) results in a change in dimension of the second electroactive polymer layer (47) parallel to the third and fourth electrode layers (43, 45),
wherein the first electrode layer (13) of the first electroactive polymer actuator is attached to the first side surface (37) of the base body (35) and the first electroactive polymer layer (17) is arranged on the side of the first electrode layer (13) facing away from the base body (35),
wherein the third electrode layer (43) of the second electroactive polymer actuator is attached to the second side surface (39) of the base body (35) and the second electroactive polymer layer (47) is arranged on the side of the third electrode layer (43) facing away from the base body (35),
wherein the first and second electroactive polymer actuators are formed such that the dimensions of the first and second electroactive polymer layers (17, 47) increase parallel to the electrode layers (13, 15, 43, 45) when an electrical voltage is applied between the first and second and between the third and fourth electrode layers (13, 15, 43, 45)
wherein the base member (7) has an edge (19) extending from the second to the fourth electrode layers (13, 45)
said first locking element (9) and said second locking element (11) being attached to said edge (19) opposite to each other
wherein the first locking element (9) is attached to the edge (19) on a first side of a center plane (21) extending centrally and parallel to the electrode layers (13, 15, 43, 45) through the base body (35), and wherein the second locking element (11) is attached to the edge (19) on a second side of the center plane (21),
wherein the first and second locking elements (9, 11) are supported on the edge (19) such that they extend at an angle to the longitudinal axis (41) and beyond the cross-section of the base body (35) with the electroactive polymer actuators perpendicular to the longitudinal axis (41) when there is no voltage between the first and second electrode layers (13, 15) and between the third and fourth electrode layers (43, 45),
wherein the first locking member (9, 11) is supported at the edge (19) such that it is pivoted toward the second locking member (11) such that it does not extend beyond the cross-section of the base body (35) having the electroactive polymer actuators perpendicular to the longitudinal axis (41) when a predetermined voltage is applied between the first and second electrode layers (13, 15), and
wherein the second locking member (11) is supported at the edge (19) such that it is pivoted toward the first locking member (11) such that it does not extend beyond the cross-section of the base body (35) with the electroactive polymer actuators perpendicular to the longitudinal axis (41) when a predetermined voltage is applied between the third and fourth electrode layers (43, 45).

9. Fastening arrangement according to claim 1 or 2, wherein the base member (7) comprises a base body (35), wherein the first and second locking elements (9, 11) are fixedly connected to the base body (35) opposite to each other,
wherein the first electroactive polymer actuator is disposed between the first and second interlocking elements (9, 11),
wherein the first electrode layer (13) is attached to the base body (35) and the first electroactive polymer layer (17) is arranged on the side of the first electrode layer (13) facing away from the base body (35),
wherein the base body (35) is elastically deformable and the first and second locking elements (9, 11) are in the locking position when the base body (35) is undeformed, and
wherein the base body (35) is elastically deformable and the first and second locking members (9, 11) are in the release position when an electric voltage is applied between the first and second electrode layers (13, 15).

10. Fastening arrangement according to claim 9, wherein the fastener is configured such that when the base body (35) is elastically deformed to cause the first and second locking members (9, 11) to assume the release position, the first and second locking members (9, 11) pivot away from each other.

## Revendications

1. Ensemble de fixation comprenant un élément de fixation (1) qui comprend une partie de base (7) et un premier élément de verrouillage (9) et un deuxième élément de verrouillage (11),
dans lequel le premier et le deuxième élément de verrouillage (9, 11) sont fixés à la partie de base (7) et peuvent prendre une position de verrouillage et une position de libération,
dans lequel la partie de base (7) comprend un premier actionneur polymère électroactif qui comprend une première couche d'électrode (13) et une deuxième couche d'électrode (15) qui s'étendent parallèlement l'une à l'autre,
une première couche de polymère électroactif (17) étant prévue entre la première et la deuxième couche d'électrode (13, 15),
le premier actionneur polymère électroactif étant conçu de telle sorte qu'une application d'une tension électrique prédéterminée entre la première et la deuxième couche d'électrode (13, 15) entraîne une modification de la dimension de la première couche polymère électroactive (17) parallèlement à la première et à la deuxième couche d'électrode (13, 15),
**caractérisé en ce que** l'élément de fixation est conçu de telle sorte que le premier et le deuxième élément de verrouillage (9, 11) sont dans la position de verrouillage lorsqu'aucune tension électrique n'est appliquée entre la première et la deuxième couche d'électrode (13, 15) et dans lequel le premier et le deuxième élément de verrouillage (9, 11) sont pivotés l'un par rapport à l'autre dans la position de libération lorsqu'une tension électrique est appliquée entre la première et la deuxième couche d'électrode (13, 15).

2. Ensemble de fixation selon la revendication 1, dans lequel le premier actionneur polymère électroactif est configuré de telle sorte que les dimensions de la première couche polymère électroactive (17) augmentent parallèlement à la première et à la deuxième couche d'électrodes (13, 15) lorsqu'une tension électrique est appliquée entre la première et la deuxième couche d'électrodes (13, 15).

3. Ensemble de fixation selon la revendication 1 ou 2, dans lequel la partie de base comprend un bord (19) qui s'étend de la première à la deuxième couche d'électrode (13, 15),
le premier élément de verrouillage (9) et le deuxième élément de verrouillage (11) étant fixés au bord (19) en étant opposés l'un à l'autre,
le premier élément de verrouillage (9) étant fixé au bord (19) sur un premier côté d'un plan médian (21) s'étendant à travers la première couche de polymère, au centre et parallèlement à la première et à la deuxième couche d'électrodes, et
le deuxième élément de verrouillage (11) étant monté sur un deuxième côté du plan médian (21).

4. Ensemble de fixation selon la revendication 3, dans lequel l'élément de fixation (1) est configuré de telle sorte que le premier élément de verrouillage (9) et le deuxième élément de verrouillage (11) pivotent en s'éloignant l'un de l'autre vers la position de libération lorsqu'une tension électrique est appliquée entre la première et la deuxième couche d'électrode (13, 15).

5. Ensemble de fixation selon la revendication 3 ou 4, dans lequel le premier élément de verrouillage (9) est disposé sur le bord (19) au niveau de la première couche d'électrodes (13) et
le deuxième élément de verrouillage (11) étant disposé sur le bord (19) au niveau de la deuxième couche d'électrodes (15).

6. Ensemble de fixation selon l'une ou plusieurs des revendications 3 à 5, dans lequel l'élément de fixation est configuré de telle sorte que le premier élément de verrouillage (9) et le deuxième élément de verrouillage (11) pivotent par rapport à la partie de base (7) et s'éloignent l'un de l'autre lorsqu'une tension électrique est appliquée entre la première et la deuxième couche d'électrodes (13, 15).

7. Ensemble de fixation selon une ou plusieurs des revendications 3 à 6, dans lequel les éléments de verrouillage (9, 11) présentent des saillies d'engagement (23) se faisant face,
dans lequel l'ensemble de fixation comprend une contre-pièce (5) comprenant un corps principal (25) et une saillie (29) s'étendant à partir de celui-ci le long d'une direction d'extension (27),
dans lequel la saillie (29) a des surfaces latérales opposées (31) qui s'étendent depuis le corps principal (25) vers une extrémité libre de la saillie, et
dans lequel des évidements sont prévus dans les surfaces latérales pour s'engager avec les saillies d'engagement.

8. Ensemble de fixation selon la revendication 1, dans lequel la partie de base (7) comprend un corps de base (35) ayant des première et deuxième surfaces latérales (37, 39) disposées de manière opposée sur le corps de base (35) et s'étendant parallèlement à un axe longitudinal (41) du corps de base (35),
dans lequel la partie de base (7) comprend un deuxième actionneur polymère électroactif,
dans lequel le deuxième actionneur polymère électroactif comprend une troisième couche d'électrode (43) et une quatrième couche d'électrode (45) qui s'étendent parallèlement l'une à l'autre,
dans lequel une deuxième couche de polymère électroactif (47) est prévue entre la troisième et la quatrième couche d'électrode (43, 45) du deuxième actionneur polymère électroactif,
le deuxième actionneur polymère électroactif étant conçu de telle sorte qu'une application d'une tension électrique entre la troisième et la quatrième couche d'électrode (43, 45) entraîne une modification de la dimension de la deuxième couche polymère électroactive (47) parallèlement à la troisième et à la quatrième couche d'électrode (43, 45),
dans lequel la première couche d'électrode (13) du premier actionneur polymère électroactif est fixée à la première surface latérale (37) du corps de base (35) et la première couche polymère électroactive (17) est disposée sur le côté de la première couche d'électrode (13) qui est éloigné du corps de base (35),
la troisième couche d'électrode (43) du deuxième actionneur polymère électroactif étant fixée à la deuxième surface latérale (39) du corps de base (35) et la deuxième couche polymère électroactive (47) étant disposée sur le côté de la troisième couche d'électrode (43) qui est opposé au corps de base (35),
dans lequel les premier et deuxième actionneurs polymères électroactifs sont formés de telle sorte que les dimensions des première et deuxième couches polymères électroactives (17, 47) augmentent parallèlement aux couches d'électrodes (13, 15, 43, 45) lorsqu'une tension électrique est appliquée entre les première et deuxième couches d'électrodes et entre les troisième et quatrième couches d'électrodes (13, 15, 43, 45)
dans lequel la partie de base (7) comprend un bord (19) s'étendant de la deuxième à la quatrième couche d'électrode (13, 45),
le premier élément de verrouillage (9) et le deuxième élément de verrouillage (11) étant fixés sur le bord (19) en étant opposés l'un à l'autre,
dans lequel le premier élément de verrouillage (9) est fixé au bord (19) sur un premier côté d'un plan central (21) s'étendant au centre et parallèlement aux couches d'électrodes (13, 15, 43, 45) à travers le corps de base (35) et dans lequel le deuxième élément de verrouillage (11) est fixé sur un deuxième côté du plan central (21),
dans lequel les premier et deuxième éléments de verrouillage (9, 11) sont maintenus sur le bord (19) de telle sorte qu'ils s'étendent selon un angle par rapport à l'axe longitudinal (41) et au-delà de la section transversale du corps de base (35) avec les actionneurs polymères électroactifs perpendiculaires à l'axe longitudinal (41) lorsqu'aucune tension n'est appliquée entre les première et deuxième couches d'électrode (13, 15) et entre les troisième et quatrième couches d'électrode (43, 45),
dans lequel le premier élément de verrouillage (9, 11) est supporté sur le bord (19) de manière à pivoter vers le deuxième élément de verrouillage (11) de telle sorte qu'il ne s'étende pas au-delà de la section transversale du corps de base (35) avec les actionneurs polymères électroactifs perpendiculairement à l'axe longitudinal (41) lorsqu'une tension prédéterminée est appliquée entre les première et deuxième couches d'électrodes (13, 15), et
dans lequel le deuxième élément de verrouillage (11) est supporté sur le bord (19) de manière à pivoter vers le premier élément de verrouillage (11) de telle sorte qu'il ne s'étende pas au-delà de la section transversale du corps de base (35) avec les actionneurs polymères électroactifs perpendiculairement à l'axe longitudinal (41) lorsqu'une tension prédéterminée est appliquée entre les troisième et quatrième couches d'électrodes (43, 45).

9. Ensemble de fixation selon la revendication 1 ou 2, dans lequel la partie de base (7) comprend un corps de base (35), le premier et le deuxième élément de verrouillage (9, 11) étant reliés de manière fixe au corps de base (35) en étant opposés l'un à l'autre,
le premier actionneur polymère électroactif étant disposé entre le premier et le deuxième élément de verrouillage (9, 11),
la première couche d'électrode (13) étant fixée au corps de base (35) et la première couche de polymère électroactif (17) étant disposée sur le côté de la première couche d'électrode (13) qui est opposé au corps de base (35),
dans lequel le corps de base (35) est élastiquement déformable et les premier et deuxième éléments de verrouillage (9, 11) sont dans la position de verrouillage lorsque le corps de base (35) n'est pas déformé, et
dans lequel le corps de base (35) est déformé élastiquement et les premier et deuxième éléments de verrouillage (9, 11) prennent la position de libération lorsqu'une tension électrique est appliquée entre les première et deuxième couches d'électrodes (13, 15).

10. Ensemble de fixation selon la revendication 9, dans lequel l'élément de fixation est configuré de telle sorte que, lorsque le corps de base (35) est déformé élastiquement pour que les premier et deuxième éléments de verrouillage (9, 11) prennent la position de libération, les premier et deuxième éléments de verrouillage (9, 11) pivotent pour s'éloigner l'un de l'autre.
